Europäisches Patentamt

European Patent Office

Office européen des brevets

(19)

(11) Veröffentlichungsnummer : **0 013 336**
**B1**

(12) # EUROPÄISCHE PATENTSCHRIFT

(45) Veröffentlichungstag der Patentschrift :
26.01.83

(21) Anmeldenummer : 79104860.6

(22) Anmeldetag : 04.12.79

(51) Int. Cl.³ : **H 03 K   5/08**, H 03 K   3/023,
**G 01 P   3/48**

(54) **Schaltungsanordnung zur Erzeugung einer Rechteckspannung.**

(30) Priorität : **15.01.79 DE 2901340**

(43) Veröffentlichungstag der Anmeldung :
**23.07.80 Patentblatt 80/15**

(45) Bekanntmachung des Hinweises auf die Patenterteilung : **26.01.83 Patentblatt 83/04**

(84) Benannte Vertragsstaaten :
**FR GB SE**

(56) Entgegenhaltungen :
**DE A 2 208 828**
**DE A 2 405 416**
**DE A 2 420 106**
**DE A 2 614 947**
**DE A 2 726 280**
**DE B 2 235 056**
**DE B 2 416 785**

(73) Patentinhaber : **VDO Adolf Schindling AG**
**Gräfstrasse 103**
**D-6000 Frankfurt/Main (DE)**

(72) Erfinder : **Schmitt, Günter**
**Robert-Koch-Strasse 80**
**D-6233 Kelkheim (DE)**

(74) Vertreter : **Könekamp, Herbert, Dipl.-Ing.**
**Sodener Strasse 9**
**D-6231 Schwalbach (DE)**

Schaltungsanordnung zur Erzeugung einer Rechteckspannung

Die Erfindung betrifft eine Schaltungsanordnung zur Erzeugung einer Rechteckspannung aus einem von einer Eingangsspannungsquelle abgegebenen Spannungssignal, mit einem als Hysteresisschalter beschalteten Differenzverstärker mit einem Rückkopplungsnetzwerk zur Erzeugung einer zeitabhängigen Hysteresisspannung mit einem Spannungsverlauf, der nach der Funktion $e^{-T/\tau}$ verläuft, wobei T die Zeit ab der letzten Umschaltung des Hysteresisschalters und $\tau$ eine vorgegebene Zeitkonstante ist.

Hysteresisschalter werden dazu verwendet, um aus dem von einem Geber als Eingangsspannungsquelle abgegebenen Spannungssignal eines beliebigen Kurvenverlaufs, der maßgeblich von der Art des Gebers bestimmt ist, eine Rechteckspannung zu erzeugen, deren Frequenz gleich der Grundfrequenz des Eingangsspannungssignals ist. Derartige bekannte Schaltungsanordnungen wirken grundsätzlich in der Weise, daß eine Verstärkerstufe eines Schmitt-Triggers rasch einen bestimmten Schaltzustand annimmt, wenn das Eingangsspannungssignal einen bestimmten Einschaltpegel erreicht und überschreitet, und daß die Verstärkerstufe rasch einen zweiten definierten Schaltzustand annimmt, wenn das Eingangsspannungssignal einen Ausschaltpegel erreicht oder unterschreitet. Der Einschaltpegel und der Ausschaltpegel liegen dabei in üblichen Hysteresisschaltern durch die Dimensionierung der Schaltungsanordnung fest.

Um mit Hysteresisschaltern Eingangsspannungssignale genau zu verarbeiten, ist es bereits bekannt (DE-OS 22 08 828), daß als Verstärker ein Differenzverstärker mit einem zweiten Eingang neben dem an die Eingangsspannungsquelle angeschlossenen Eingang vorgesehen ist und daß dieser zweite Eingang über eine Widerstand-Kondensator-Kombination mit dem Ausgang des Differenzverstärkers verbunden ist. Bei dieser Schaltungsanordnung sind die Einschalt- und Ausschaltpegel des Schmitt-Triggers nicht wie üblich auf bestimmte Werte festgelegt, sondern ändern sich selbsttätig entsprechend den Frequenzänderungen und ihren proportionalen Amplitudenänderungen des Eingangsspannungssignals. Bei einer Variation der Frequenz und der damit verbundenen Variation der Amplitude des Eingangsspannungssignals wird der Schaltpegel des Hysteresisschalters stets so verschoben, daß das Verhältnis zwischen dem Spitzenwert bzw. der Amplitude der Eingangsspannung und dem Schaltpegel konstant bleibt. Mit dieser Schaltungsanordnung können über einen weiten Frequenzbereich Nutzsignal und Störsignal, die überlagert in die Schaltungsanordnung eingespeist werden, mit größtmöglicher Störsicherheit getrennt werden. Dies gilt für solche Eingangsspannungssignale, deren Amplitude proportional der Frequenz ist und die insbesondere überlagerte Störsignale aufweisen, die vom Geber selbst erzeugt werden und die ein konstantes Amplitudenverhältnis zum Nutsignal haben, d.h. deren Amplitude mit steigender Frequenz ebenfalls zunimmt. Derartige Eingangsspannungssignale werden insbesondere von Induktivgebern abgegeben, die vorzugsweise in Verbindung mit einer sogenannten elektrischen Welle zur Übertragung von Messwerten und insbesondere in einem Wegstreckenzähler in Kraftfahrzeugen eingesetzt werden.

Dieser bekannte Hysteresisschalter hat den Nachteil, daß er nur dann hinsichtlich der Störsicherheit zufriedenstellende Ergebnisse liefert, wenn die Eingangsspannungssignale einen zeitlich symmetrischen Verlauf aufweisen.

Es ist daher Aufgabe der Erfindung, unter Vermeidung der Nachteile des bekannten Hysteresisschalters Eingangsspannungssignale mit größtmöglicher Störsicherheit zu verarbeiten, deren Frequenz und Amplitude in einem weiten Bereich schwankt und die insbesondere einen zeitlich unsymmetrischen Verlauf haben. Diese maximale Störsicherheit soll auch bei raschen Schwankungen des Eingangsspannungssignals gegeben sein. Der zusätzliche Aufwand zur Verwirklichung einer solchen Schaltungsanordnung soll möglichst gering sein.

Diese Aufgabe wird erfindungsgemäß dadurch gelöst, daß die Zeitkonstante $\tau$ für die Einschaltphase und die Zeitkonstante $\tau$ für die Ausschaltphase des Hysteresisschalters verschieden groß sind.

Durch diese Maßnahme kann in wenig aufwendiger Weise erreicht werden, daß für jeden Impuls des Eingangsspannungssignals eine optimale Störunterdrückung vorhanden ist.

Gemäß einer vorteilhaften Ausführungsform der Erfindung sind bei einem eine Widerstand-Kondensator-Kombination enthaltenden Rückkopplungsnetzwerk zwei Dioden derart in der Kombination angeordnet, daß während der Einschaltphase eine eine erste Zeitkonstante erzeugende Widerstand-Kondensator-Unterkombination und während der Ausschaltphase eine eine zweite Zeitkonstante erzeugende Widerstand-Kondensator-Unterkombination wirksam geschaltet ist.

Die Erfindung wird im folgenden anhand der Zeichnung näher erläutert. Es zeigen:

Figur 1 ein stark vereinfachtes Blockschaltbild der erfindungsgemäßen Schaltungsanordnung;

Figur 2 eine Ausführungsform eines bekannten symmetrisch wirkenden Rückkoppelungsnetzwerks;

Figur 3 eine Ausführungsform eines erfindungsgemäßen unsymmetrisch wirkenden Rückkoppelungsnetzwerks;

Figur 4a den Eingangsspannungsverlauf und den Verlauf der Hysteresisspannung bei einer kleinen Eingangsspannungsfrequenz;

Figur 4b den zugehörigen Verlauf der Ausgangsspannung ;

Figur 5a den Verlauf der Eingangsspannung und der Hysteresisspannung bei einer mittleren Frequenz der Eingangsspannung und

Figur 5b den zugehörigen Verlauf der Ausgangsspannung.

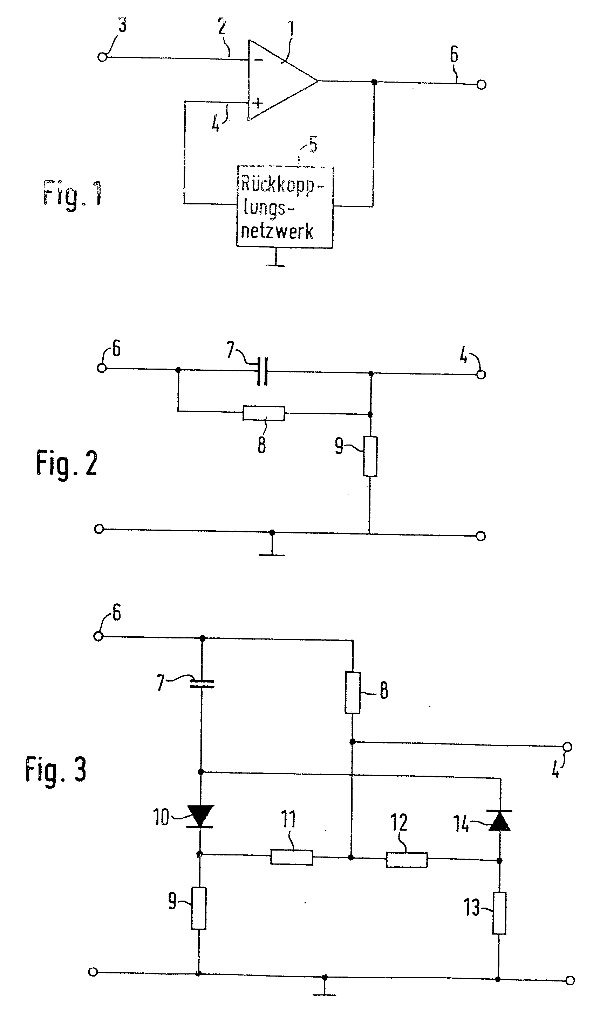

In Figur 1 ist mit 1 ein Differenzverstärker bezeichnet, der als Hysteresisschalter beschaltet ist. Der Differenzverstärker hat einen ersten Eingang 2, der über eine Klemme 3 an eine Eingangssignalspannungsquelle — in der Zeichnung nicht dargestellt — angeschlossen werden kann. Ein zweiter Eingang 4 des Differenzverstärkers steht über ein Rückkoppelungsnetzwerk 5 mit einem Ausgang 6 des Differenzverstärkers in Verbindung.

Bei einer in Fig. 2 dargestellten, bekannten Schaltungsanordnung besteht das Rückkoppelungsnetzwerk 5 aus einer Widerstand-Kondensator-Kombination mit einem Kondensator 7, einem parallel geschalteten Widerstand 8 in einem Längszweig und einem Widerstand 9 in einem Querzweig zwischen dem Ausgang 6 und dem Eingang 4 des Differenzverstärkers. Die Widerstand-Kondensator-Kombination bewirkt im stationären Zustand eine konstante Hysteresisspannung, der dynamisch eine zeitabhängige Hysteresisspannung überlagert ist.

Figur 3 zeigt ein erfindungsgemäßes Rückkoppelungsnetzwerk für unsymmetrische Hysteresisspannungsverläufe beim Einschalten und Ausschalten des Hysteresisschalters. In der Ausführungsform nach Figur 3 sind gleiche Bauelemente wie in Figur 2 mit übereinstimmenden Bezugszeichen bezeichnet. Die Ausführungsform nach Figur 3 liefert ebenfalls im stationären Zustand eine konstante Hysteresisspannung und dynamisch eine überlagerte, die Ausgangsspannung an dem Ausgang 6 differenzierende zeitabhängige Hysteresisspannung. Die Zeitkonstante $\tau$ dieser zeitabhängigen Hysteresisspannung ist jedoch für die beiden möglichen Schaltfälle des Hysteresisschalters unterschiedlich gewählt, je nachdem, ob die Ausgangsspannung am Ausgang 6 von dem Zustand « High » auf den Zustand « Low » übergeht oder aber umgekehrt. Hierzu steht der Widerstand 9 nicht direkt mit dem Widerstand 8 und dem Kondensator 7 in Verbindung ; er ist vielmehr über eine erste Diode 10 an den Kondensator 7 angeschlossen und über einen Widerstand 11 an den Widerstand 8. Parallel zu den somit in Reihe geschalteten Widerständen 9 und 11 sind zwei weitere Widerstände 12 und 13 angeordnet. Von deren gemeinsamen Verbindungspunkt ist eine zweite Diode 14 in umgekehrter Durchflussrichtung wie die erste Diode 10 an den Kondensator 7 geschaltet.

Unter der Zusatzbedingung, daß der Quotient des Widerstandswerts des Widerstands 13 zu der Summe der Widerstandswerte der Widerstände 13, 11 und 12 gleich dem Quotienten des Widerstandswerts 9 zu der Summe der Widerstandswerte 9, 11 und 12 ist, liefert dieses Rückkoppelungsnetzwerk an dem Eingang 6 des Differenzverstärkers eine in beiden Schaltzustandsänderungen gleiche konstante Hysteresisspannung, jedoch bei beiden Schaltzustandsänderungen dynamische Hysteresisspannungen mit unterschiedlichen Zeitkonstanten der zeitlichen Spannungsverminderung, da bei einer ersten Schaltzustandsänderung die Diode 10 leitet, die Diode 14 jedoch nicht, während bei einer zweiten Schaltzustandsänderung die Diode 14 leitet, im Gegensatz zu der Diode 10.

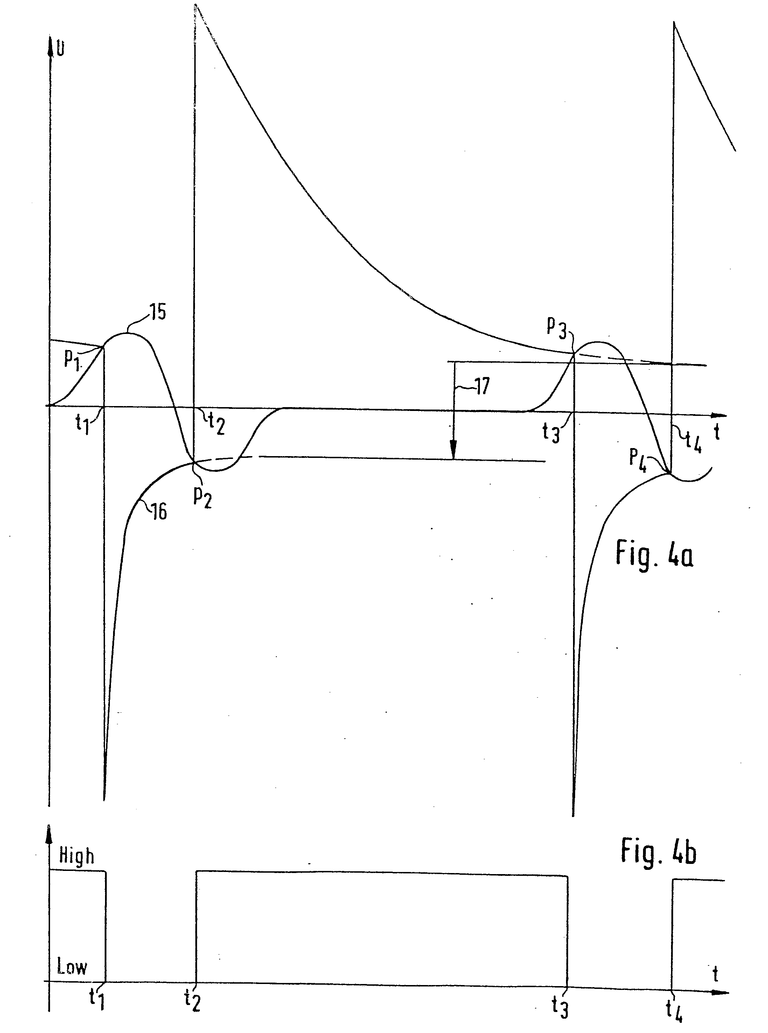

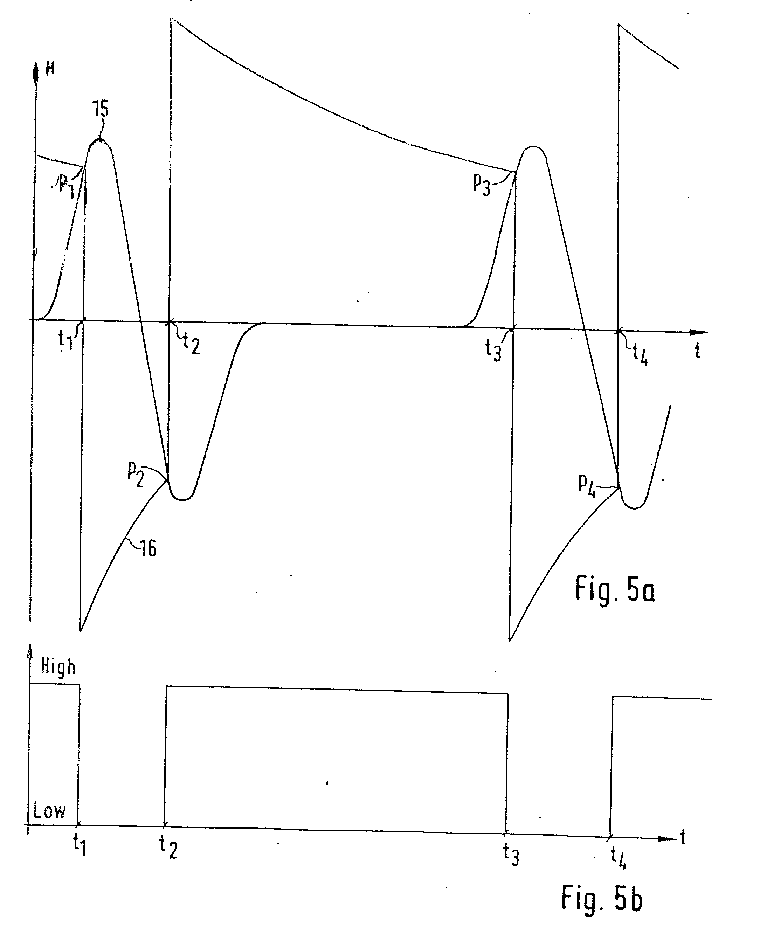

In den Figuren 4a, 4b, 5a, 5b sind Spannungsverläufe dargestellt, die mit der Schaltungsanordnung nach Figur 1 in Verbindung mit einem Rückkoppelungsnetzwerk nach Figur 3 erzielt werden :

In Figur 4a ist mit 15 der Verlauf einer Eingangsspannung bezeichnet, die an dem ersten Eingang 2 des Differenzverstärkers anliegt.

Der Kurvenzug der Hysteresisspannung, mit dem der zweite Eingang 4 des Differenzverstärkers beaufschlagt wird, ist mit 16 bezeichnet. Diese Hysteresisspannung setzt sich zusammen aus einer statischen Hysteresisspannung, die mit einem Pfeil 17 angedeutet ist und die unabhängig von der Frequenz der Eingangsspannung einen bestimmten Betrag beibehält. Dieser statischen Hysteresisspannung ist eine dynamische Hysteresisspannung, nämlich eine von den Umschaltzeitpunkten $t_1$, $t_2$, $t_3$, $t_4$ exponentiell abfallende Spannung überlagert. Die Umschaltung zu den Zeitpunkten $t_1$, $t_2$, $t_3$, $t_4$ erfolgt, wenn die Hysteresisspannung die Eingangsspannung erreicht, wodurch zugleich die Einschalt- bzw. Ausschaltpegel $P_1$, $P_2$, $P_3$, $P_4$ definiert sind.

Figur 4b gibt zeitgleich den Verlauf der Ausgangsspannung an dem Ausgang des Differenzverstärkers wieder. Aus den Figuren 4a und 4b ergibt sich zusammen, daß der Hysteresisschalter zu dem Zeitpunkt $t_1$ ausgeschaltet wird, wobei die zeitabhängige Hysteresisspannung ihren — negativen — Maximalwert erreicht, von dem sie exponentiell zu der statischen Hysteresisspannung hin abfällt, solange, bis sie die Eingangsspannung 15 zum Zeitpunkt $t_2$ erreicht. In diesem Augenblick wird der Hysteresisschalter umgeschaltet bzw. eingeschaltet. Dadurch entsteht ein neuer Sprung der dynamischen Hysteresisspannung auf einen — positiven — Maximalwert, von dem sie wiederum exponentiell bis zu dem Zeitpunkt $t_3$ abfällt, zu dem eine erneute Umschaltung eingeleitet wird. Es sei noch darauf hingewiesen, daß die Zeitkonstanten, mit denen die dynamische Hysteresisspannung abklingt, zwischen den Umschaltzeiten $t_1$ bis $t_2$ verhältnismäßig klein und zwischen $t_2$ und $t_3$ verhältnismäßig groß ist, entsprechend der Dimensionierung des unsymmetrisch wirkenden Rückkoppelungsnetzwerks nach Figur 3. Im Zusammenhang mit Figur 4a wird noch darauf hingewiesen, daß die Amplitude der Eingangsspannung 15 zu den Schaltpegel $P_1$, $P_2$, $P_3$, $P_4$ in einem bestimmten Verhältnis steht.

Der Verlauf der Eingangsspannung 15 in Figur 5a unterscheidet sich von demjenigen in Figur 4a dadurch, daß die Frequenz und die Amplitude höher sind. Bei gleichartigem Verlauf der Hysteresisspannung erreicht diese Hysteresisspannung den Wert der Eingangsspannung 15 bei größeren Beträgen der Schaltpegel $P_1$ und $P_4$, und zwar deswegen, weil infolge der geringeren Periodendauer die dynamische Hysteresisspannung noch nicht so weit abgefallen ist wie in dem Vergleichsfall in Figur 4a. Dies wird bei der Betrachtung der Figur 5a besonders deutlich bei der Verfolgung des Verlaufs der Hysteresisspannung zwischen den Umschaltzeiten $t_2$ und $t_3$. Die Folge davon ist, daß das Verhältnis der Amplitude der Eingangsspannung 15 zu dem Schaltpegel $P_1$ bzw. $P_2$ bzw. $P_3$ bzw. $P_4$ das gleiche ist wie in dem Vergleichsfall in Figur 4a. Figur 5b zeigt den Verlauf der rechteckförmigen Ausgangsspannung, deren Pulsfolgefrequenz gleich der Grundfrequenz der Eingangsspannung 15 ist.

Da das Verhältnis der Amplitude der Eingangsspannung zu dem Schaltpegel in beiden Vergleichsfällen nach Figur 4a und 5a das gleiche ist, wird eine größtmögliche Störsicherheit erreicht.

## Ansprüche

1. Schaltungsanordnung zur Erzeugung einer Rechteckspannung aus einem von einer Eingangsspannungsquelle abgegebenen Spannungssignal, mit einem als Hysteresisschalter beschalteten Differenzverstärker mit einem Rückkopplungsnetzwerk zur Erzeugung einer zeitabhängigen Hysteresisspannung mit einem Spannungsverlauf, der nach der Funktion $e^{-T/\tau}$ verläuft, wobei T die Zeit ab der letzten Umschaltung des Hysteresisschalters und $\tau$ eine vorgegebene Zeitkonstante ist, dadurch gekennzeichnet, daß die Zeitkonstante $\tau$ für die Einschaltphase und die Zeitkonstante $\tau$ für die Ausschaltphase des Hysteresisschalters verschieden groß sind.

2. Schaltungsanordnung nach Anspruch 1, dadurch gekennzeichnet, daß bei einem eine Widerstand-Kondensator-Kombination enthaltenden Rückkopplungsnetzwerk zwei Dioden (10, 14) derart in der Kombination angeordnet sind, daß während der Einschaltphase eine eine erste Zeitkonstante erzeugende Widerstand-Kondensator-Unterkombination und während der Ausschaltphase eine eine zweite Zeitkonstante erzeugende Widerstand-Kondensator-Unterkombination wirksam geschaltet ist.

## Claims

1. Circuit arrangement for producing a square-wave voltage from a voltage signal transmitted by an input voltage source, comprising a differential amplifier connected as a hysteresis switch with a feedback network for producing a time-dependent hysteresis voltage with a voltage curve in accordance with the function $e^{-T/\tau}$, where T is the time from the last switching of the hysteresis switch and $\tau$ is a predetermined time constant, characterised in that the time constant $\tau$ for the switch-on phase and the time constant $\tau$ for the switch-off phase of the hysteresis switch are of different magnitudes.

2. Circuit arrangement according to Claim 1, characterised in that in a feedback network containing a resistor-capacitor combination two diodes (10, 14) are disposed in the combination in such a manner that during the switch-on phase a resistor-capacitor subcombination producing a first time constant is switched into operation and during the switch-off phase a resistor-capacitor subcombination producing a second time constant is switched into operation.

## Revendications

1. Montage pour engendrer une tension rectangulaire à partir d'un signal de tension délivré par une source de tension d'entrée, comportant un amplificateur différentiel connecté, en tant que commutateur à hystérésis, avec un circuit de réaction pour produire une tension d'hystérésis dépendant du temps, dont l'allure de tension correspond à la fonction $e^{-T/\tau}$, T étant le temps à partir de la dernière commutation dudit commutateur à hystérésis et $\tau$ étant une constante de temps prédéterminée, montage caractérisé par le fait que la constante de temps $\tau$ pour la phase d'enclenchement et la constante de temps $\tau$ pour la phase de déclenchement du commutateur à hystérésis ont des grandeurs différentes.

2. Montage selon la revendication 1, caractérisé par le fait que, dans un circuit de réaction renfermant une combinaison résistance-condensateur, se trouvent deux diodes (10, 14) qui sont disposées, dans la combinaison, de telle sorte que, pendant la phase d'enclenchement, soit activée une sous-combinaison résistance-condensateur engendrant une première constante de temps et que, pendant la phase de déclenchement, soit activée une sous-combinaison résistance-condensateur engendrant une seconde constante de temps.

Fig. 1

Fig. 2

Fig. 3

Fig. 4a

Fig. 4b

Fig. 5a

Fig. 5b